# EUROPEAN PATENT SPECIFICATION

(11) **EP 2 059 105 B1**
(45) Date of publication and mention of the grant of the patent: **04.01.2012**
(21) Application number: 07021813.6
(22) Date of filing: 09.11.2007
(51) Int. Cl.: H05K 7/20

(54) **System and method for climate control**
System und Verfahren zur Klimatisierung
Système et procédé pour le contrôle climatique

(43) Date of publication of application: 13.05.2009
(60) Divisional application: 11008439.9
(73) Proprietor: Knürr GmbH, 94424 Arnstorf (DE)
(72) Inventor: Gallmann, Martin, 5436 Würenlos (CH); Honold Olivier, 8703 Erlenbach (CH); Reiter, Rupert, 84378 Dietersburg (DE)
(74) Representative: Röthinger, Rainer

(56) References cited:
- US-A1- 2003 050 003
- US-A1- 2003 067 745
- US-A1- 2005 099 770
- US-A1- 2005 187 664
- US-A1- 2006 139 877
- US-A1- 2006 168 975
- US-A1- 2006 260 338

## Description

### Field of the Invention

This invention relates to a system and method for climate control. More particularly, this invention relates to a technique for efficiently controlling climate parameters of racks.

### Background

Electronic devices, such as computers and their periphery have become widespread. Where such devices have to be accumulated to form large systems, it has become common to organize the elements in racks. Conventionally, racks of a certain width (e.g. 19 inches) are used and the size of an electronic element is usually given in height units, where one height unit equals 1,75 inches = 44,45 mm. Computer racks of one standard size offer space for up to 42 high units.

Many devices that can be housed inside such racks consume enough electrical power to heat up their surroundings. As there is a limit to the temperatures at which electronic devices may be operated, means for maintaining the temperature inside these devices underneath a critical level must be taken. To this ends, many electronic devices comprise electrical fans which assure cooling of the precious electronic part inside the devices. However, if electronic devices are packed tightly, the cooling effect may not be sufficient using air of room temperature. Inside data centres, where often large numbers of computers and their periphery are hosted in a plurality of racks, it is common to have climate control systems that control the temperature and humidity of the air inside the data centre.

In many data centres, flow of the ambient air through the electronic devices inside the racks and further around the data centre is more or less arbitrary, as the hosted systems (oftentimes legacy systems, the age of which may vary over several decades) are not designed to support an organized flow of air through the data centre. Consequently, the climate control units inside the data centres are often controlled such that it is ensured that the climate conditions inside the data centre do not trespass certain predefined limits at any point throughout the room. Should for instance one of the devices produce a large amount of heat, and its ambient temperature therefore rise, a thus controlled climate control unit, if it detects the "hotspot", would increase its performance for the complete room. While a higher performance of the climate control unit will largely not harm any of the other installed electronic devices, such generalized cooling will generally consume more power than necessary.

Document US 2006/0260338 A1 describes a data center cooling solution. One embodiment has two baffles in a substantially vertical orientation. The baffles can extend substantially across the distance between the top of the front faces of the first and second rows, to form a roof on the cold aisle. The baffles inhibit mixing of cold air released from the cold aisle with warm air flowing horizontally.

Document US 2006/0139877 A1 discloses a data center having a cooling unit that releases cooled air through an air turning member. Upper restriction panels extend from the racks on each side of a cold aisle. The cold air leaves the cold aisle over the edges of the upper restriction panels.

It is therefore an object of the invention to provide a system for controlling climate inside a rack that is efficient and easy to implement starting from standard components.

### Summary of the Invention

According to one aspect, the invention solves this problem by providing a system for controlling climate parameters inside at least one rack according to claim 1. The rack may be an industry standard rack of 19 inch width. It may have a height of 42 units, where one unit equals 1,75 inches = 44,45 mm. Generally, the rack may also have different dimensions. In one embodiment, each of the racks in the system has the same height, width and depth.

The climate parameters comprise at least a temperature. Climate parameters may also comprise a pressure, a level of sound, a composition, a concentration of dust and a humidity, or any other parameter that may influence the climate inside the at least one rack.

The medium may essentially be air. Using a gas as medium, any kind of gas can be used, such as air, nitrogen or freon. The composition of the gas may be varied to the requirements in the vicinity of the at least one rack.

The duct may be situated essentially below the at least one rack. In one embodiment, it is a task of the medium to modify a temperature inside the rack and medium of a lower temperature may be delivered towards the rack from below the rack and medium of a higher temperature may be removed from the rack above the rack. Generally, any other arrangement of the duct with respect to the rack is also possible.

The duct may comprise a lower and an upper plane, the at least one rack being situated on top of the upper plane. In this case, the duct may run between the two layers of a double bottom. A space between the two layers of the double bottom may be any height that will permit a sufficient flow of medium, in one embodiment between 20 and 120 cm, in another embodiment between 40 and 60 cm.

A space between the lower and the upper plane may also comprise provisioning lines connected to the at least one rack. Such provisioning lines may comprise power lines, communication lines in the shape of wire-based or fibre-optics lines and supply- and removal lines for liquids or gases. Any other kind of provisioning lines is also possible. In one embodiment, provisioning lines run inside the duct. In a further embodiment, the duct is identical to the space between the two planes. Where lines pierce the duct, they may be sealed with respect to the duct, to prevent an exchange of medium along the pierce point. Such a sealing may comprise any kind of sealing known in the art. In one embodiment, lines that pierce the duct are sealed using brush strips. While it may not be necessary to ensure a 100 % sealing of the planes, any loss of media through a pierce point may lead to a decrease in efficiency of the system.

The system may also comprise a housing for closing a path along which the medium may circulate between the at least one rack and the climate control unit, the duct forming a portion of the path. The housing may comprise floors, ceilings and walls of a data centre room. The climate control unit may be situated inside the housing. It may be fed by medium from a higher level inside the housing and it may perform climate control on the fed medium and then forward the medium through the duct towards the at least one rack. The climate control unit may also be situated outside the housing. In this case, further ducts may be used to permit exchange of medium between the at least one rack and the climate control unit.

The system may also comprise a conveyor for conveying the medium. The conveyor may be situated at any point along the path along which the medium is exchanged between the climate control unit and the at least one rack.

The conveyor may form a portion of the ducts. In another embodiment, the conveyor may be part of the climate control unit. In still another embodiment, the conveyor may be used to collect air from inside the housing and convey it towards the climate control unit. In a variant, more than one conveyor is situated along the medium circulation path.

The at least one rack may have a supply side for supplying medium to the at least one rack and a removal side opposite the supply side for removing medium from the at least one rack. In yet another embodiment, the supply side and the removal side are not on opposite sides. They may be on different sides of the rack, though. In one embodiment, the rack is roughly block-shaped and comprises a front- and a backside. The frontside may be the supply side and the backside may be the removal side for the medium. Orientation of the supply- and removal-sides may be dependent on a preferred direction of movements of medium through the rack. This direction, in turn, may be dependent on the preferences of an object to be held inside the rack, such as electronic parts, i.e. a computer.

The duct may be arranged at one of the supply side and the removal side of the at least one rack such that essentially all of the medium passing through the ducts passes through the at least one rack. In one embodiment, the duct terminates in the vicinity of the rack and shielding means are used to seal the flow of medium from the end of the duct to one of the supply side and the removal side of the at least one rack. Again, it is not required to provide a 100 % sealing between any of the sides of the least one rack and the end of the ducts, but any leak may degrade the efficiency of the system.

The system may comprise a plurality of racks arranged such as to form at least one aisle between them and that for each aisle, one of the supply sides and the removal sides of all racks adjacent to the aisle face towards the aisle. In one embodiment, all racks are block-shaped and have same height, width and depth. The racks may be arranged in two columns spaced apart far enough to permit maintenance access to the items contained inside the racks. All of the supply sides may face the aisle and all of the removal sides may be on those sides of the racks that face away from the aisle. In a different embodiment, all of the removal sides face the aisle and all of the supply sides face away from the aisle.

The duct may connect the aisle with the climate control unit. In one embodiment, the space between two planes of a double bottom inside a data centre room serves as the duct and the upper plane has openings that permit the medium to flow between the duct and the aisle. To increase serviceability of the racks, a grill may serve as a portion of floor that separates the aisle from the duct.

The aisle may comprise a termination element at one of its ends to seal the aisle. In another embodiment, the aisle may have more ends that are not closed by racks but by termination elements. The termination elements may comprise doors to permit servicing personal to enter and leave the aisle. The doors may be of transparent or opaque material. The doors may be sliding doors or swing doors. In one embodiment, the doors are swing doors and open up to 180° to form part of an escape route for servicing personal.

The system comprises at least one cover element sealing the aisle at a top end. The cover element may be transparent to accommodate illumination inside the aisle. The cover element is spaced apart from the racks by elements that are not permeable for the medium.

The cover element may comprise a medium bleeding opening for bleeding medium from or into the aisle. The bleeding opening may comprise a sensor that is used for determining a direction of flow of medium through the bleeding opening. In one embodiment, such a sensor comprises an airscrew which turns in a direction according to the direction of a medium flowing through it. The sensor may also comprise a switch that is attached to a sail which catches some of the media and turns into a direction dependent on a direction of flow of the medium. In another embodiment, properties of the medium on both ends of the bleeding opening are compared. This may for instance be a temperature or a pressure of the medium. Both of the sensors may be located closed to the bleeding opening or spaced apart from it along the path of circulation.

The at least one rack may comprise a plurality of mounting spaces for accommodating payload. The mounting spaces may have a width of 19 inches. Mounting spaces that are not occupied by payload may be sealed towards the aisle. Such unused spaces may also be sealed towards the side of the rack facing away from the aisle. These seals may be removable to permit later installation of payload. The mounting spaces may be sealed with respect to the payload to prevent uncontrolled medium flow through the at least one rack.

The payload situated in one of the mounting spaces may comprise electrically powered equipment. Such equipment may comprise computers, storage systems, processing units, storage units, network elements such as switches, hubs, routers and any other kind of electrical equipment, especially the kind of equipment that can generally be found inside data centrals.

The payload may comprise a private medium conveyor for conveying medium from the supply side to the removal side of the at least one rack. In one embodiment, all payloads inside a rack are arranged such that the supply side of the payload matches the supply side of the rack, and the removal side of the payload matches the removal side of the rack. Furthermore, a plurality of racks may be arranged in one row and all supply sides of all racks face in one direction while all removal sides of all racks face the opposite side of the racks. The payload may also comprise a plurality of private medium conveyors.

The payload may comprise a controller for controlling the private medium conveyor on the basis of payload parameters. Such payload parameters may comprise sensor readings or a determined state of the payload. The payload may also comprise communication means for exchanging information about its internal state and the performance and operation of its private medium conveyor with other devices.

The system may comprise a plurality of sensors and a master control unit connected to each sensor, wherein the master control unit is adapted to control performance of at least one of the conveyor and the climate control unit. The sensors may be positioned in a number of locations along and adjacent to the circulation path of the system. For example, sensors may sample any of the above-explained climate parameters and be situated at different positions inside each payload, inside payload spaces where no payload is installed, on the top and bottom of each rack, on the supply and removal side of each rack, at positions throughout the duct, around various positions near the conveyor, at various positions around the climate control unit and on the flow path between the climate control unit and the rack outside the duct. The master control unit may determine the performance of the conveyor and/or the climate control unit on the basis of these elements. The master control unit may also use information exchanged with payload installed inside any of the at least one racks.

The system may comprise a first sensor that is located close to the bleeding opening. In one variant, the first sensor is located on the aisle side of the bleeding opening. In another embodiment, the first sensor is located on the other side of the bleeding opening.

The system may comprise a second sensor that is located at a distance to the bleeding opening. In one embodiment, the second sensor is located as far away as possible from the rack along the medium circulation path, but before the medium enters the climate control unit. In another embodiment, the second sensor is located somewhere along the medium path between the bleeding hole and the climate control unit. In yet another embodiment, the second temperature sensor may be located somewhere along the medium path between the climate control unit and the end of the duct, close to the rack.

The plurality of sensors may comprise temperature sensors. In addition to the variety of climate sensors explained above, it may also comprise power consumption sensor, radiation sensors, current- and voltage-sensors and any other kind of sensors that may sample useful information to control operation of the climate control unit and the conveyor, respectively.

The climate control unit may comprise a slave control unit connected to the master control unit. The slave control unit may be part of the climate control unit and be operable through a user interface located at the climate control unit or via a remote operation unit. The slave control unit may be adapted to communicate with the master control unit and it may be adapted to accept commands from the master control units.

The slave control units may be adapted to sustain operation of the climate control unit in case communication with the master control unit is interrupted. To this ends, the slave control units may control a mode of operation of the climate control units that is no longer dependent on the readouts of sensors to which no communication exists. In this way, operation of a data centre may be ensured even in the case of a failed master controlled unit. The climate control unit may be adapted to be connected to at least two different power supplies. The power supplies may be independent from each other. At least one of the power supplies may be interruption free. This may comprise a battery-based solution. Each of the power supplies may also be backed-up by a electric generator which starts operation if a connection to an external supply for electricity fails.

According to another aspect of the invention, the problem is solved through a method for controlling at least one climate parameter of a medium inside a rack through which the medium is run according to claim 24. The method may be carried out via a system as described above.

The at least one climate parameter comprises a temperature. It may also comprise a humidity or a composition of the medium.

The turnover difference may be determined on the basis of a flow of medium through a duct that connects the supply side of the rack with a medium removal side of the rack. This duct may be identical to the bleeding hole described above. The duct may be small in comparison to the size of the rack. In one embodiment, the duct may be at a position close to the rack, but as far away as possible from the conveyor. The duct may be a simple hole in an isolation material, or it may a tube of any sort.

A performance of the conveyor may be increased if a medium flow from a removal side to the supply side is determined. Similarly, performance of the conveyor may be decreased if said medium flow is no longer detected. Correspondence between a detected medium flow through the duct and a change in performance of the conveyor may be done with a standard regulation module, such as an P, I, D, PI, PD, ID or PID regulation module.

In another embodiment, a medium flow of a certain magnitude is considered to correspond to a turnover of medium through the rack that does not differ from a turnover of medium through the conveyor. This "zero" flow may be defined in any direction through the duct.

The climate parameter is a temperature, and a flow direction through the duct may be determined on the basis of a difference between a temperature of the medium inside the duct and a temperature of the medium at the location before the current enters the rack. A certain difference in temperature may be indicative of a turnover of medium through the rack that is equal to the turnover of medium to the conveyor. In correspondence to a change in temperature difference between the two points, performance of the conveyor may be controlled.

### Detailed Description of preferred embodiments

Preferred embodiments of the invention will now be discussed with reference to the figures, in which:
- Fig. 1:: shows a rack layout without separation of cold and warm aisles;
- Fig. 2:: shows another rack layout with separation of cold and warm aisles;
- Fig. 3:: shows a rack layout embodiment according to the invention;

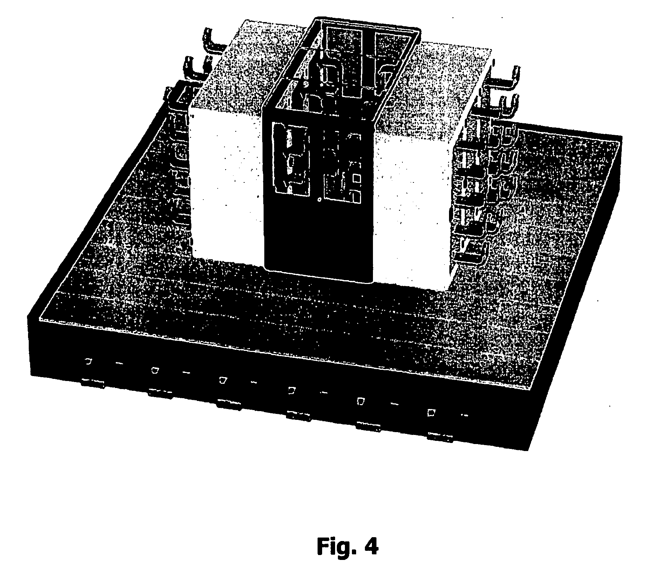

- Fig. 4:: shows a perspective view of another rack layout embodiment according to the invention;
- Fig. 5:: shows an overview of a data centre with one rack layout em- bodiment according to the invention;

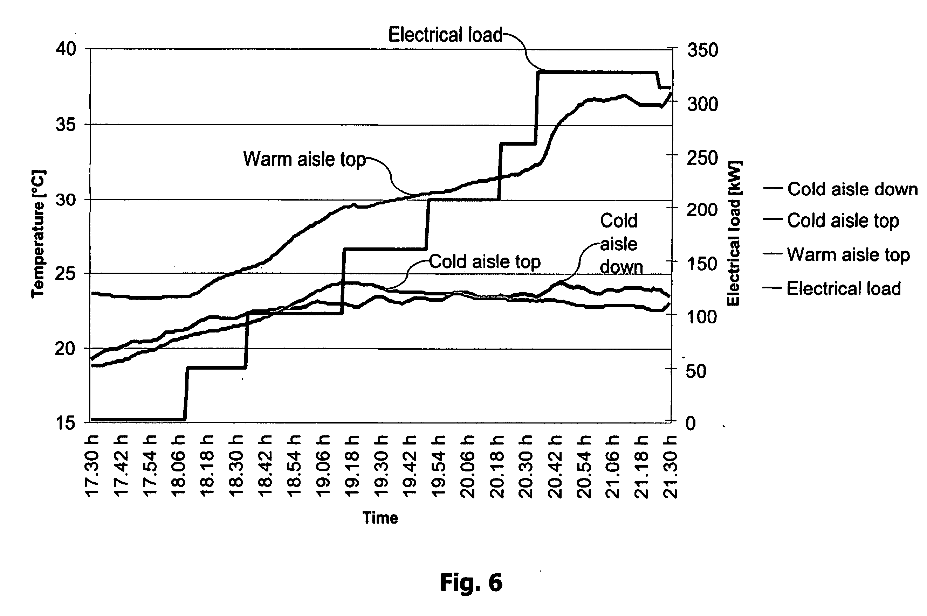

- Fig. 6:: shows results of a load test of a data centre;
- Fig. 7:: is cancelled.

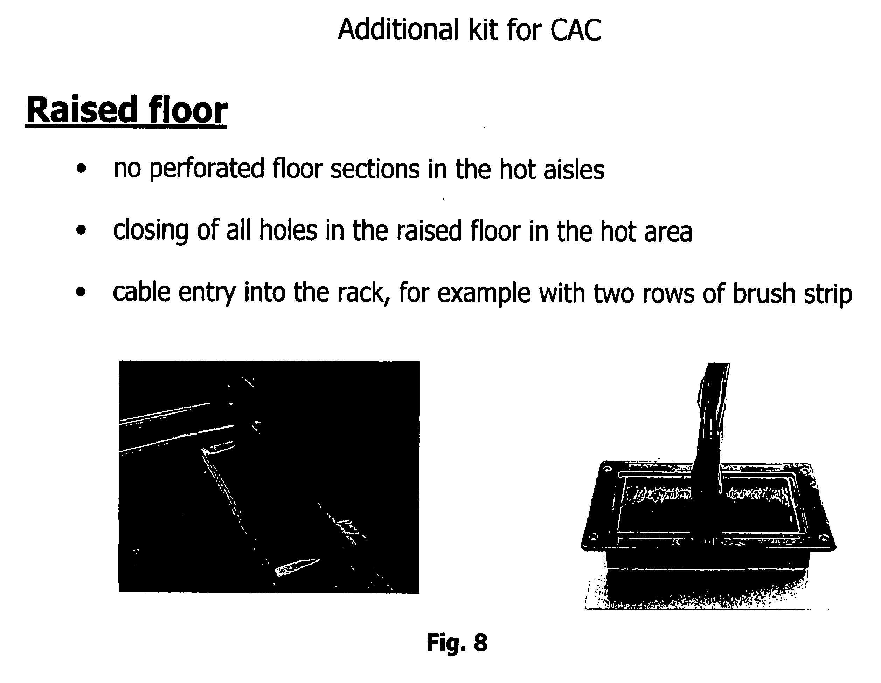

- Fig. 8:: shows details for sealing an aisle;

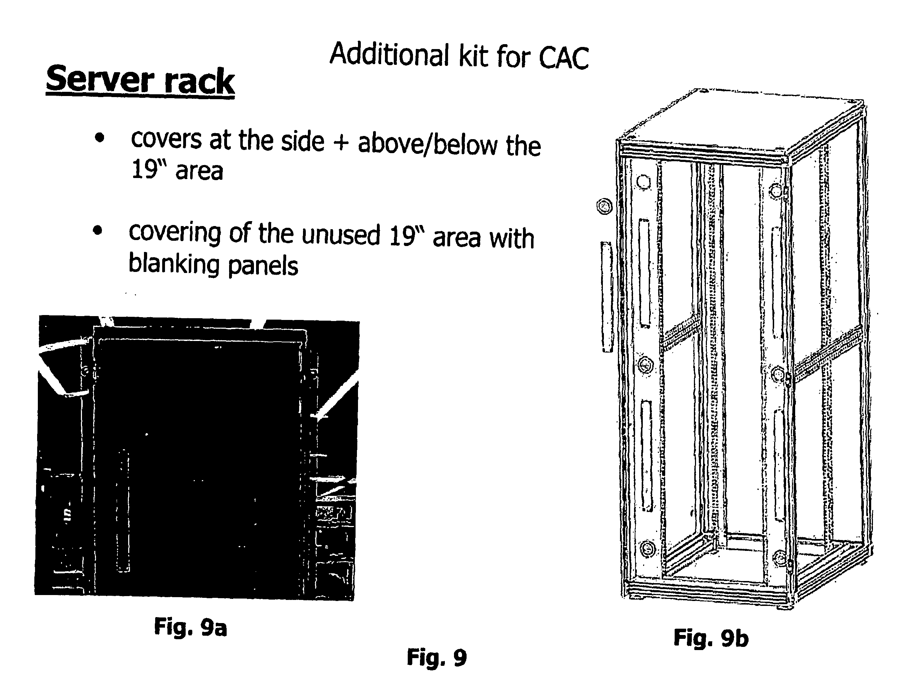

- Fig. 9a and 9b:: show details of sealing a server rack;

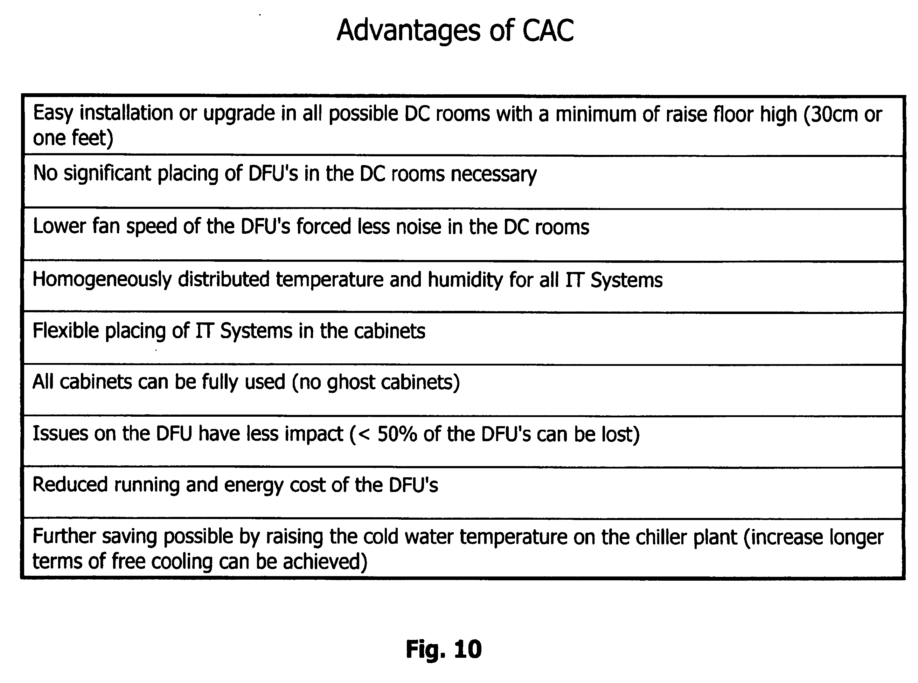

- Fig. 10:: shows advantages of a closed air compartment (CAC) system;

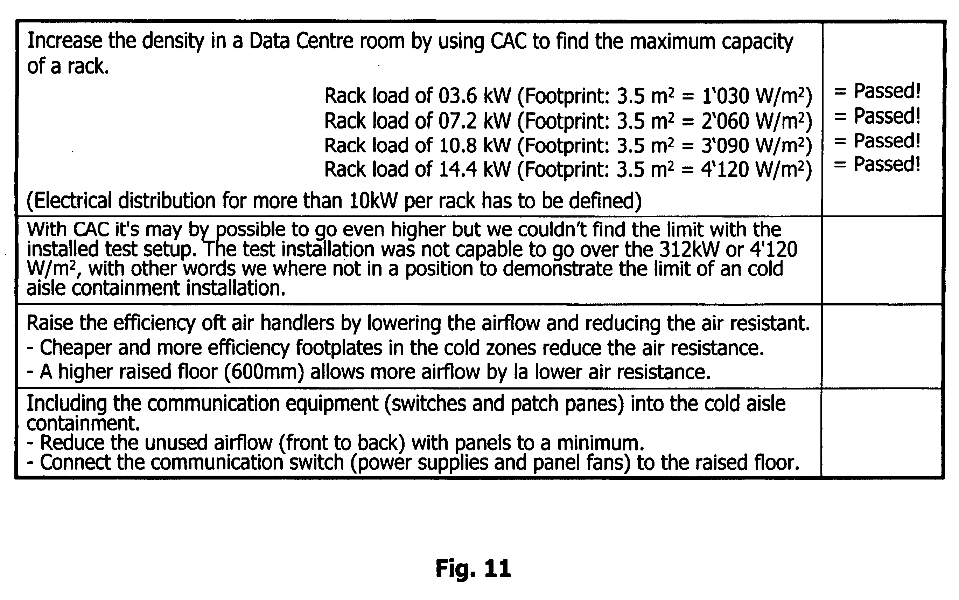

- Fig. 11:: shows performance parameters of a CAC;

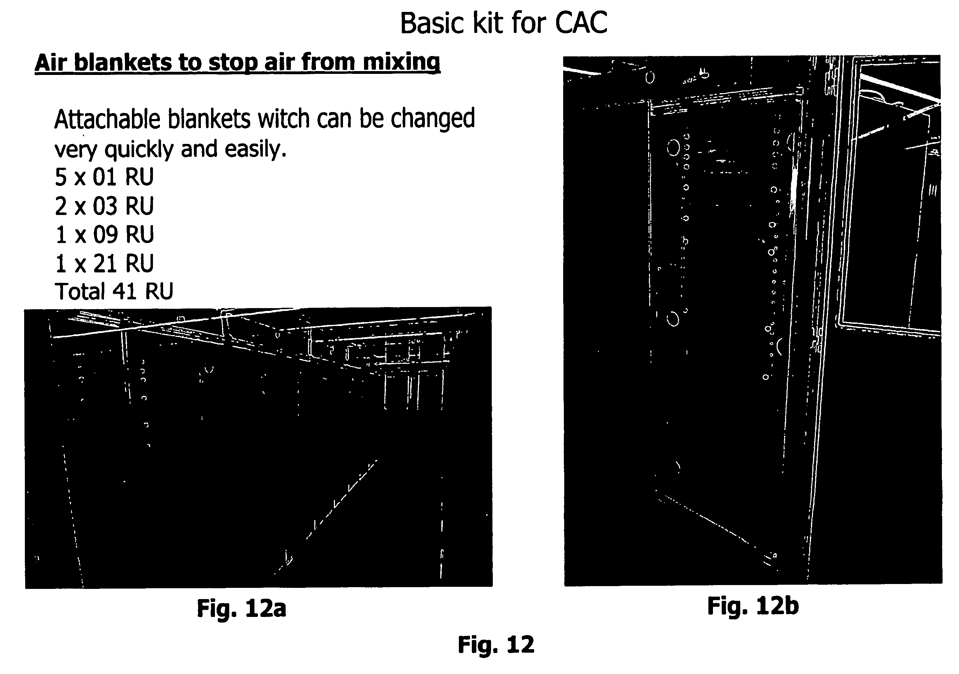

- Figs. 12a and 12 b:: show details of sealing the CAC;

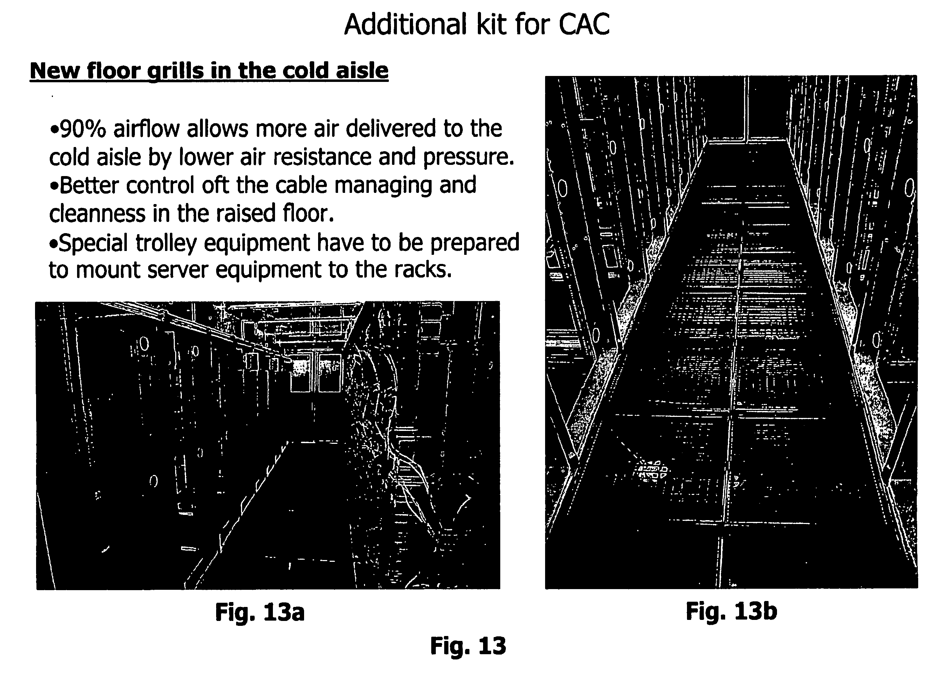

- Figs. 13a and 13b:: show details of floor grills in a CAC aisle;

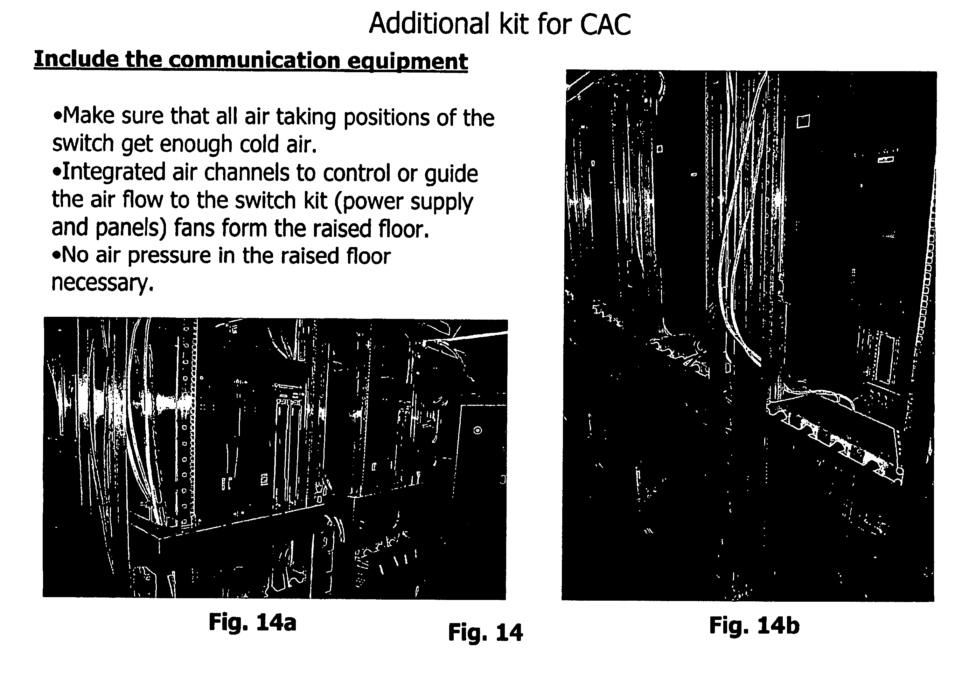

- Figs. 14a and 14b:: show details concerning the cabling of racks;

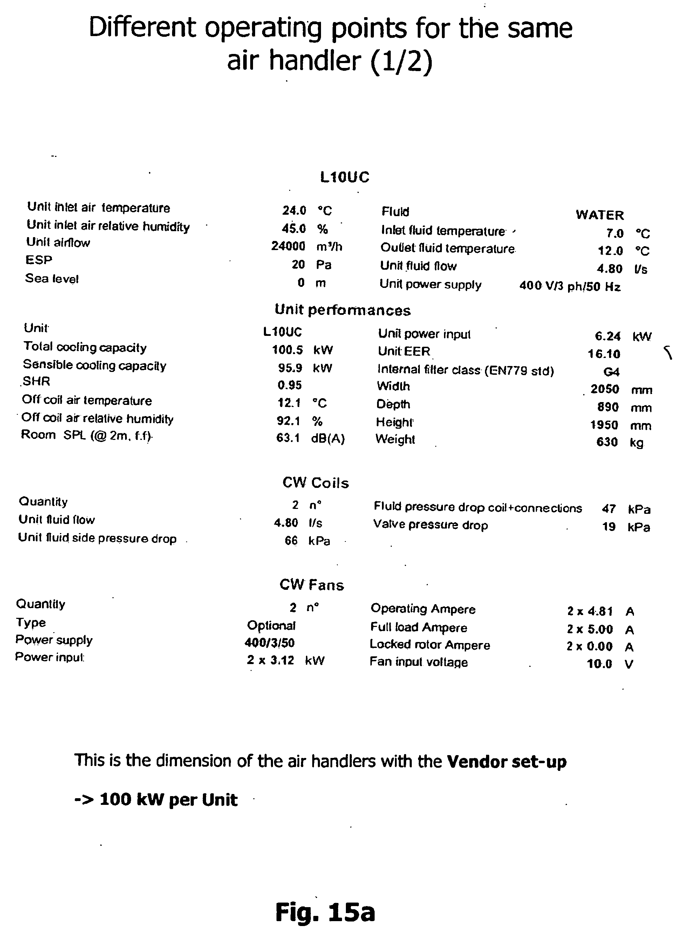

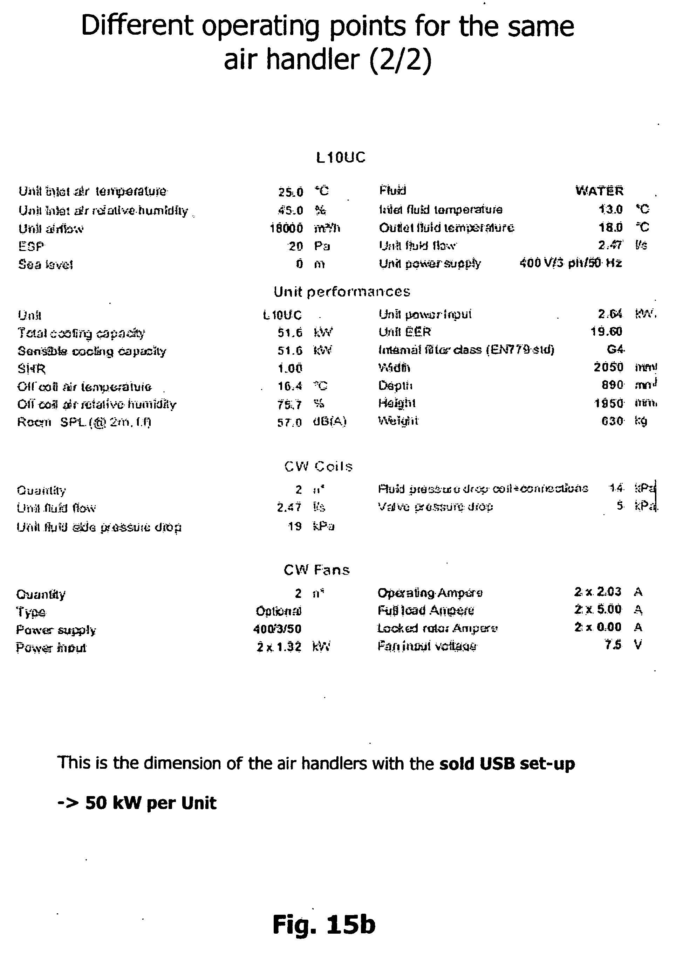

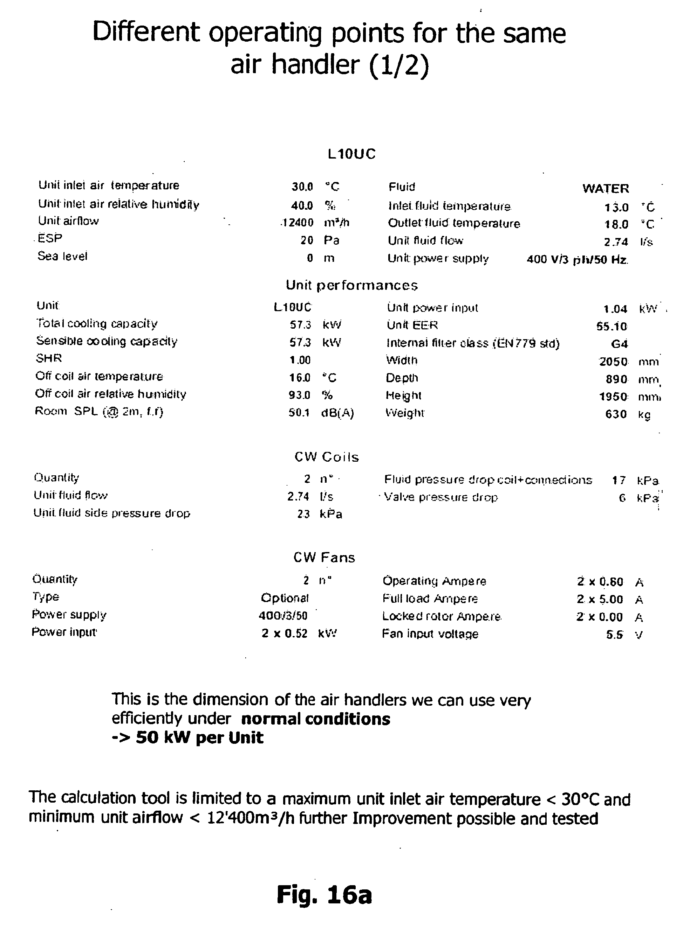

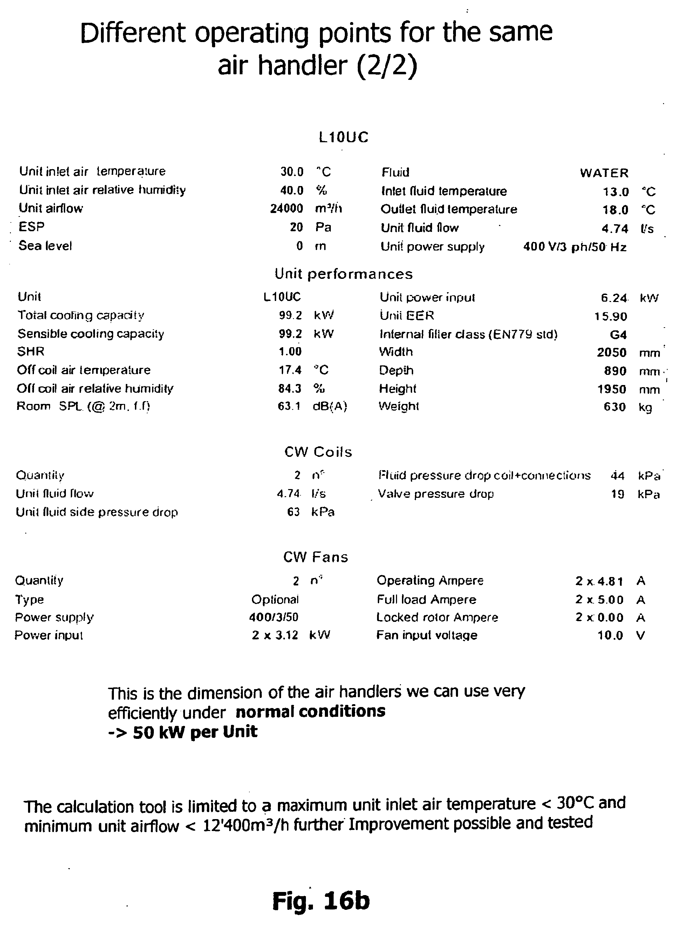

- Figs. 15 and 16: show diffent operating points for air handlers.

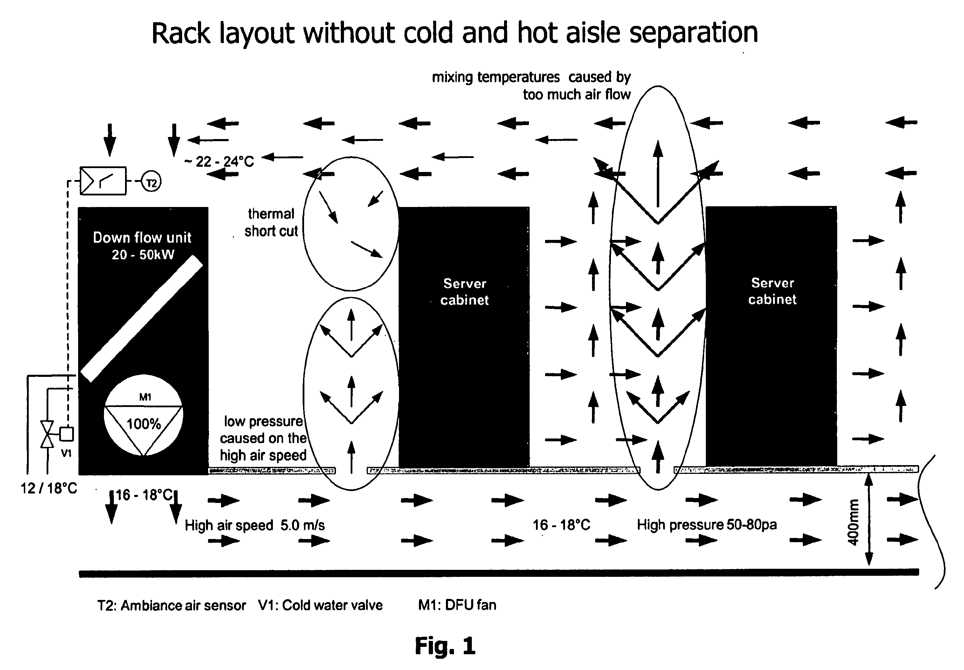

Fig. 1 shows a rack layout without cold and hot aisle separation. This kind of rack layout is common in data centres that host legacy systems that were not specially built for supporting a ventilation path inside a data centre. As can be seen in the tall ellipsis to the right hand side of the figure, cold air from below the server cabinets and heated air that is ejected from the server cabinets get mixed, which reduces the efficiency of the data centre air conditioning.

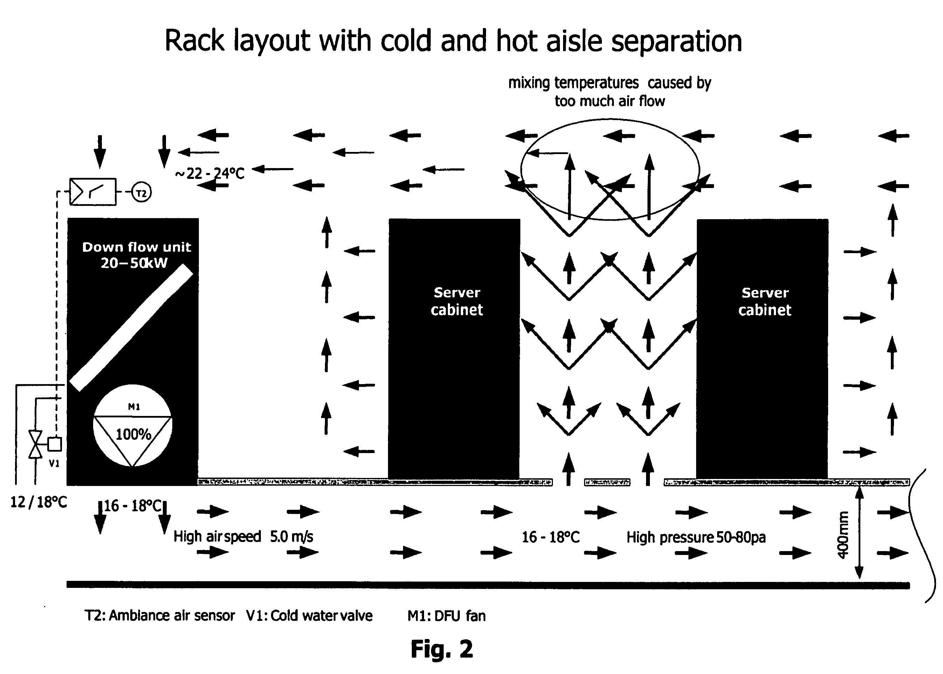

Fig. 2 shows another variant of rack layout inside a data centre, with cold and hot aisle separation. Indicated by an ellipsis is a zone where cold and heated air flows mix and thus degrade efficiency of the cooling system.

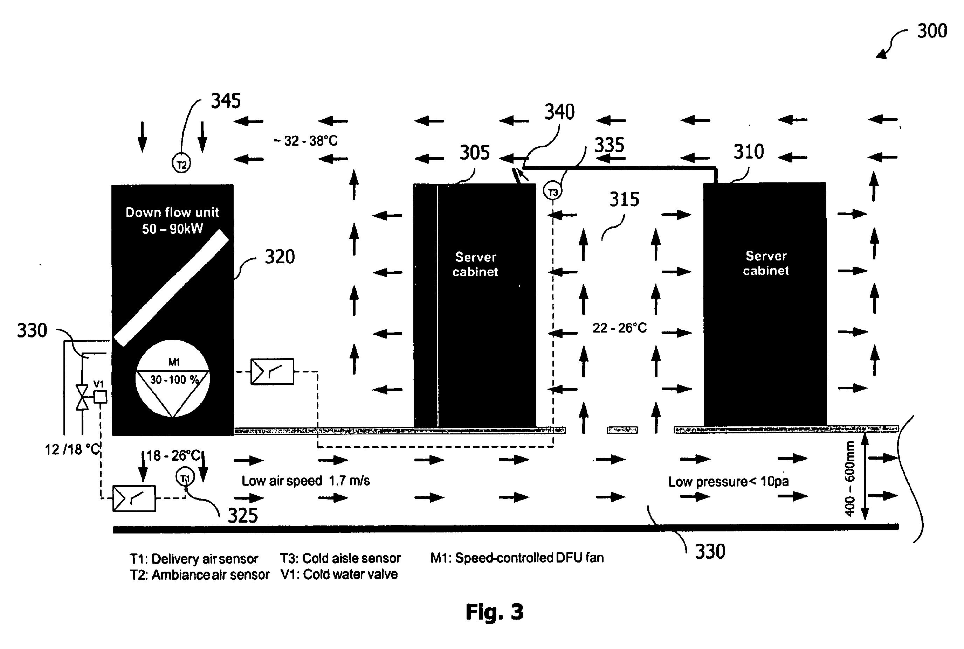

Fig. 3 shows a system 300 for maintaining a predetermined temperature inside server cabinets 305 and 310. The sever cabinets 305 and 310 are located on both sides of an aisle 315. Cool air rises from below towards the server cabinets 305, 310 which have their cooling air supply sides facing towards the aisle 315. The air is heated while it passes through the server cabinets 305 and 310. Outside the server cabinets 305 and 310, the warmed air rises towards the ceiling and is eventually sucked in by a climate control unit 320. The climate control unit 320 cools the sucked- in air and supplies it to a duct that leads back to the aisle 315.

In the displayed embodiment, the climate control unit 320 is a so-called chiller, which is attached to cold water supply and warm water removal tubes. The supply-side water may have a temperature around 5 to 15°C, and in one embodiment the temperature lies between 11 and 13°C. The water on the removal side may have a temperature that is higher than the temperature at the supply side. Specifically, the water temperature at the removal side may be between 12 and 22°C, and in one embodiment around 16 to 19°C.

A temperature sensor 325 senses the temperature of the air that is output by the climate control unit 320. Depending on the determined temperature a valve 330 is operated, which controls flow of cooling water through the climate control unit 320. A regulation may be used that keeps the temperature of the air output by the climate control unit 320 at a temperature between 15 and 30°C. More particularly, the output air temperature may be between 18 and 26°C. In one embodiment, the temperature of the output air may be 20°C.

The climate control unit 320 also comprises a conveyor (not displayed) for propelling cool air into a duct 325. During normal operation, the conveyor may propel the cooling air at an airspeed of 1 to 3 m per second. In one embodiment, the airspeed may be between 1,5 and 2,2 m per second. Speed of the air is related to a height of the duct 330, along which the cold air is propelled from the climate control unit 320 towards the aisle 315. Height of the duct may be between 150 and 800 mm. In one embodiment, the height may be between 300 and 600 mm. In yet another embodiment, the height may be between 400 and 500 mm. Depending on the airspeed and the height of the duct 330, air pressure inside the duct 330 may be low, for instance no more than 10 pascal over the air pressure inside the data centre (not displayed).

At a top end of the aisle 315, a temperature sensor 335 is located near a bleeding hole (or duct) 340. During normal operation, a temperature determined by temperature sensor 335 may lie between 18 and 30°C. In another embodiment, the temperature may lie between 22 and 26°C.

Another temperature sensor 345 is located near an intake of climate control unit 320. Here, the air warmed by the server cabinets may have a temperature around 32 to 38°C. Under certain conditions, the temperature may rise to values between 35 and 42°C.

Starting from normal operation, should equipment inside one of the server cabinets 305 and 310 dissipate more heat and therefore require more cooling, it will use internal fans to propel more cooling air per time from the aisle 315 through the server cabinet 305 or 310. By this, the pressure inside the aisle 315 with respect to the rest of the data centre will drop slightly. Consequently, an amount of warm air will be sucked through bleeding hole 340 towards the inside of the aisle 315. As this suckedin air will pass at the temperature sensor 335, a temperature difference between the temperature determined by temperature sensor 335 and the temperature determined by sensor 325 can be determined. This may be interpreted as a requirement for more cooling air inside the aisle 315. Using a conveyor (not shown) integrated into climate control unit 320, more cool air per time is propelled through the duct 330. As there exists a regulation system that holds the temperature of the air coming out of the climate control unit 320 at a constant temperature, there is effectively more cool air per time available to the server cabinets 305 and 310. Therefore, the pressure difference between the aisle 315 and the rest of the data centre will no longer exist and no more warm air is sucked through the bleeding hole 340. Therefore the temperature that is registered by the temperature sensor 335 will drop back to a more normal value.

Similarly, should the devices located in the server cabinets 305 and 310 have less power to dissipate and will therefore convey less air from the aisle 315 through the server cabinets 305 and 310, the temperature registered by temperature sensor 335 will drop with respect to the temperature registered by temperature sensor 325. This may be interpreted as an excess of cold air inside the aisle 315, and propelling of cold air from the climate control unit 320 into the duct 330 may be decreased.

### Ambient air temperature regulation of down flow units "traditional"

Existing regulations of down flow units are concentrated on ambience or return air regulation. That makes sense, if you are not using cold and hot aisle containment. If the airflow is not controlled the ambience air is hard to guarantee. So the best way to guaranty the ambience temperature for the IT- systems is to cool down the whole room on 22-26°C. The ambient or return air controls the cold water valve. The delivery air can have a temperature from 16-24°C depending on the return air temperature.

### Delivery air temperature regulation of down flow units "new"

The idea of the new control strategy focuses on a controlled airflow to the cold aisle. Based on the fact, that the IT-systems take the cold air out of the cold aisle by themselves, heat the air up internally and blow the hot air in the hot aisle, it is not necessary to cool down the whole data centre room. That is the reason to change the control strategy form ambience and return air regulation to delivery air regulation.

### Ambient temperature regulation of the cold aisle "new"

The basic idea is to deliver as much cold air to the cold aisle as the cold aisle demands. Sensors in the cold aisle measured the temperature on the top of the server racks. The temperature set point is two till five degrees higher than the delivery temperature set point. If the temperature on the top of the servers is lower than the set point, this is an indication that the down flow units deliver too much cold air to the cold aisle. If the temperature is higher than the set point, is this an indication that the down flow units deliver not enough cold air to the cold aisle. To control the cold air delivery to the cold aisles the fan speed has to be controlled by a regulation.

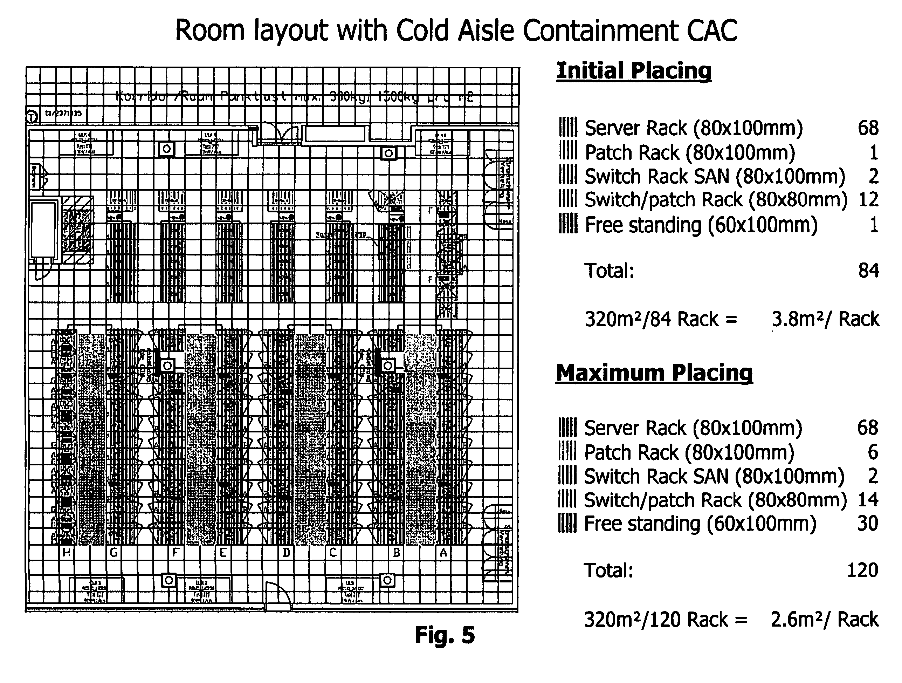

Referring to Fig. 5 once again, the basic setup of an exemplary data centre will now be discussed. The room will be cooled by six down flow units. A master regulation is responsible for the down flow unit management. The six down flow units are connected to the master as a slave. Each down flow unit is connected to two power distributions. To switch from one power unit to the other a manual switch has to be switched.

The six down flow units are connected to two different power supply systems. As long as both power supply systems are up, units 1, 3 and 5 are connected to the first power supply system and units 2, 4 and 6 are connected to the second power supply system. Should the first power supply system fail, units 1, 3 and 5 are switched to the second power supply system, so that all units are fed from the second power supply system. Vice versa, should the second power supply system fail, units 2, 4 and 6 are switched to the first power supply system, so that all units are fed by the first power supply system.

The communication to the down flow units has to be over a standard connection (Ethernet for example). All commands and pieces of information will be communicated over this communication. In case of communication failure all slaves have to react correctly to hold the temperature in the data centre room. Safety functions have to be implemented.

From the master control the following functions have to be implemented:
- Status of the down flow units (on / off / stand-by)
- Fan speed for the down flow units (30 - 100%) depend on the cold aisle temperature
- Set point of delivery air temperature
- Collection and visualisation of all information from the slave regulations

The following information elements will connect to the master control:
- Ambient air sensors (cold aisle) 16 piece
- Water leak detectors (6 piece)
- Down flow units (6 piece), all information and commands by bus (Ethernet)
- Measured data about electricity consumption of the Power distribution units

### 2.2.1 Automatic operating of the Master controller

The Master controller manages the status of every down flow unit in the data centre room. The statuses will be written to the slave. In case of a communication failure the last status will be saved.

A down flow unit can have the following statuses:
- ON: The down flow unit regulate the delivery air and the fan speed to the given (master control) set points.
- STAND-BY: The down flow unit is shut off. In case of failure of down flow unit, whitch is on the status ON, or in case of a communication failure the down flow units turn on. The delivery air temperature will be regulated by the "last known" set point. Fan speed run on default set point (100% adjustable).
- OFF: The down flow unit is shut off and will not turn on in case of any failure.

All commands, set point changes and informations are visualised and controlled on a touch panel and on the BMS (Building Management System).

### 2.2.2 Fan speed regulation of the down flow units

The range of the fan speed set point of the down flow units can be between 30% and 100% and is adjustable from the control panel (minimum and maximum).

The demand of the fan speed is depending on the cold aisle temperature. The cold aisle temperature is measured twice per cold aisle on the top of the racks. The highest temperature in the cold aisles regulates the fan speed of all down flow units. The highest temperature in the cold aisle should be regulated (PI- controller) by the give set point (master control) of 24°C (adjustable on the master control and the BMS system). As soon the temperature in the cold aisle is lower than the set point the fan speed will be reduced till the temperature is back on the set point. Contrariwise if the temperature is higher than the set point.

All down flow units run parallel with the same fan speed.

### Safety functions

### Master failure

The master controller is connected to the UPS. In case of master failure (communication alert) the down flow units with the status "ON" run with maximum fan speed. The down flow units with the status "STAND-BY" turn on and run with maximum fan speed.

The monitoring and controlling from the BMS System is off line.
- The alarming T1ₑₗₑₖ go over GEIS and RMS
- Alarming T1ₑₗₑₖ will be visualised on the panel of the master control till acknowledgement.

### Water leak detection

Each down flow unit have a water leak detection. Alarming T1_{mech} will be produced. The down flow unit will not be shut off.
- The alarming T1ₑₗₑₖ go over GEIS and RMS
- Alarming T1ₑₗₑₖ will be visualised on the panel of the master control till acknowledgement.

### Cold aisle temperature monitoring

The cold aisle temperature is monitored by the air temperature sensors in the cold aisle. Is the temperature in the cold aisle rising over a given (master controller) first set point the down flow units with the status "STAND-BY" will turn on.

Alarming T2_{mech} be visualised on the panel of the master control till acknowledgement.

A raise of the temperature in the cold aisle over a given (master controller) second set point a alarm T1_{mech} will be initiated.
Alarming T1_{mech} go over GEIS and RMS
Alarming T1_{mech} will be visualised on the panel of the master control till acknowledgement.

### Status monitoring

The status of every down flow unit is monitored. Is the status of a down flow unit after 4 minutes not the same as from the master controller ordered, a down flow unit with the status "STAND-BY" will turned on and an alarm T1_{mech} will be initiated. The command to the failure down flow unit will not be taken back.

Alarming T2_{mech} be visualised on the panel of the master control till acknowledgement.

### Sensor monitoring

All sensors will be monitored. In case of failure an alarm T2ₑₗₑₖ will be initiated. No actions will be initiated. The failing sensor will be setting inactive.

Alarming T2_{mech} be visualised on the panel of the master control till acknowledgement.

### Fire detection system

The fire detection has no influence to the status of the down flow units.

### Visualisation

### Master panel

All informations will be visualised in a touch panel. The status, set points and parameters of the master controller and the down flow units can be changed.

Control lights:
- Alarm T1_{mech} (rot)
- Alarm T1ₑₗₑₖ (rot)
- Nicht-Normal-Betrieb (weiß)
- Watchdog (rot)

There are no control lights an on the down flow units.

### Further Remarks

To provide a better understanding, some of the details that are essential for the invention will be picked up one more time in this section.
- Increase the density in a Data Centre room by using CAC
   - Rack layout without cold and hot aisle / CAC = 0 - 500W/m2
   - Rack layout with cold and hot aisle = 0 -1'000W/m2
   - Rack layout with cold aisle containment = 0 -1'500W/m2
      (with CAC it's may by possible to go even higher but we no tests yet)
- Raise the efficiency of the Down flow units by lowering the airflow. In a 300m² room with 1'000W/m² density we can avoid ~ 36'000 CHF energy cost per year
   - This result is based on the higher efficiency of the DFU's
- Avoid "hot spots" and use the whole Rack space. Air volume in cold aisles can be best controlled in closed environments.
   - Multiple IT load in all cabinets possible (homogeneously distributed temperature and humidity)

### Advantages of CAC

- Easy installation or upgrade in all possible DC rooms with a minimum of raise floor high (30cm or one feet)
- No significant placing of DFU's in the DC rooms necessary
- Lower fan speed of the DFU's forced less noise in the DC rooms
- Homogeneously distributed temperature and humidity for all IT Systems
- Flexible placing of IT Systems in the cabinets
- All cabinets can be fully used (no ghost cabinets)
- Issues on the DFU have less impact (< 50% of the DFU's can be lost)
- Reduced running and energy cost of the DFU's
- Further saving possible by raising the cold water temperature on the chiller plant (longer periods of free cooling can be achieved).

## Claims

1. A system (300) for controlling at least one climate parameter inside a plurality of racks (305, 310) arranged such as to form at least one aisle (315) between them, the system comprising:
- at least one climate control unit (320) adapted to control the at least one climate parameter of a gaseous medium;
- a duct (330) for exchanging the medium between the plurality of racks and the climate control unit, the duct being adapted to deliver the medium towards the racks from below the racks; a temperature sensor (335) located at a top end of the aisle and adapted to sample a temperature as the climate parameters, **characterised by**
- a cover element sealing the aisle at a top end, the cover element extending in a horizontal plane across the aisle, above the racks, and vertically spaced apart from the racks by elements that are not permeable for the medium; and wherein
- the aisle is sealed such that essentially all of the medium passing through the duct passes through the racks.

2. The system according to claim 1, further comprising a housing adapted to close a path along which the medium circulates between the plurality of racks and the climate control unit.

3. The system according to claim 1, **characterised in that** the racks have a supply side for supplying medium to the racks and a removal side for removing medium from the racks.

4. The system according to claim 3, **characterized in that** the removal side is opposite to the supply side.

5. The system according to claim 3, **characterized in that** the supply side and the removal side are on different sides of the rack other than opposite sides.

6. The system according to one of the claims 3 to 5, **characterized in that** for each aisle, one of the supply sides and the removal sides of all racks adjacent to the aisle face towards the aisle.

7. The system according to one of claims 3 to 6, **characterized in that** all of the supply sides face the aisle and all of the removal sides are on those sides of the racks that face away from the aisle.

8. The system according to one of the previous claims, **characterized in that** the duct forms a portion of the path.

9. The system according to one of the previous claims, **characterized in that** the duct is situated essentially below the plurality of racks.

10. The system according to one of the previous claims, **characterized in that** a grill serves as a portion of floor that separates the aisle from the duct.

11. The system according to one of the previous claims, **characterized in that** the cover element is transparent to accommodate illumination inside the aisle.

12. The system according to one of the previous claims, **characterized in that** the aisle comprises a termination element adapted to seal the aisle at one of its ends.

13. The system according to claim 12, **characterized in that** the termination element is a door.

14. The system according to claim 13, **characterized in that** the door is a sliding door.

15. The system according to one of the previous claims, **characterized in that** the plurality of racks comprises a plurality of mounting spaces for accommodating payload.

16. The system according to claim 15, **characterized in that** the payload comprises a private medium conveyor for conveying medium from the supply side to the removal side of its rack.

17. The system according to claim 15 or 16, **characterized in that** the mounting spaces are sealed with respect to the payload to prevent uncontrolled medium flow through the racks.

18. The system according to one of the claims 15 to 17, **characterized in that** mounting spaces that are not occupied by payload are sealed towards the aisle.

19. The system according to one of the claims 15 to 18, **characterized in that** the supply side of the payload matches the supply side of the rack, and the removal side of the payload matches the removal side of the rack.

20. The system according to one of the previous claims, further comprising a conveyor situated along the path along which the medium is exchanged between the climate control unit and the plurality of racks, the conveyor adapted to collect air from inside the housing and convey it towards the climate control unit.

21. The system according to claim 20, **characterized in that** the sampled temperature registered by the temperature sensor (335) lies between 22 and 26°C, and a drop of the sampled temperature causes the conveyor to decrease its propelling of cold air from the climate control unit into the duct.

22. The system according to one of the previous claims, **characterized in that** the climate control unit is adapted to be connected to at least two different power supplies, at least one of the power supply being interruption free.

23. The system according to one of the previous claims, **characterized in that** at least one of the climate control unit and the conveyor are situated outside of the housing.

24. A method of controlling at least one climate parameter inside a plurality of racks (305, 310) arranged such as to form at least one aisle (315) between them, the method comprising:
- controlling the at least one climate parameter of a gaseous medium;
- exchanging the medium between the plurality of racks and the climate control unit through a duct delivering the medium towards the racks from below the racks;
- sampling a temperature at a top end of the aisle as the climate parameter; **characterized by** sealing the aisle at a top end by a cover element extending in a horizontal plane across the aisle, above the racks, and vertically spaced apart from the racks by elements that are not permeable for the medium; and where in the aisle is sealed such that essentially all of the medium passing through the duct passes through the racks.

## Patentansprüche

1. System (300) zum Steuern wenigstens eines Klimaparameters innerhalb einer Vielzahl an Racks (305, 310), die so angeordnet sind, dass sie wenigstens einen Gang (315) zwischen sich bilden, wobei das System umfasst:
- wenigstens eine Klimasteuereinheit (320) zum Steuern des wenigstens einen Klimaparameters eines gasförmigen Mediums;
- einen Kanal (330) zum Austausch des Mediums zwischen der Vielzahl an Racks und der Klimasteuereinheit, wobei der Kanal dazu ausgebildet ist, das Medium in Richtung der Racks von unterhalb der Racks zuzuführen;
- einen am oberen Ende des Gangs angeordneten Temperatursensor (335) zum Abtasten einer Temperatur als dem Klimaparameter, **gekennzeichnet durch**
- ein den Gang an einem oberen Ende abdichtendes Abdeckungselement, wobei das Abdeckungselement sich in einer horizontalen Ebene über den Gang erstreckt, oberhalb der Racks, und von den Racks vertikal beabstandet ist **durch** Elemente, die für das Medium undurchlässig sind; und wobei
- der Gang derart abgedichtet ist, dass im Wesentlichen das gesamte den Gang durchlaufende Medium die Racks durchläuft.

2. System nach Anspruch 1, ferner umfassend ein Gehäuse, das zum Schließen eines Wegs, den entlang das Medium zwischen der Vielzahl an Racks und der Klimasteuereinheit zirkuliert.

3. System nach Anspruch 1, **dadurch gekennzeichnet, dass** die Racks eine Zuführungsseite zum Zuführen des Mediums zu den Racks und eine Abführungsseite zum Abführen des Mediums von den Racks aufweist.

4. System nach Anspruch 3, **dadurch gekennzeichnet, dass** die Abführungsseite gegenüberliegend der Zuführungsseite ist.

5. System nach Anspruch 3, **dadurch gekennzeichnet, dass** die Zuführungsseite und die Abführungsseite an verschiedenen Seiten des Racks sind, die nicht gegenüberliegende Seiten sind.

6. System nach einem der Ansprüche 3 bis 5, **dadurch gekennzeichnet, dass** für jeden Gang entweder die Zuführungsseiten oder die Abführungsseiten aller an den Gang angrenzenden Racks zum Gang hin ausgerichtet sind.

7. System nach einem der Ansprüche 3 bis 6, **dadurch gekennzeichnet, dass** sämtliche der Zuführungsseiten dem Gang zugewandt sind und sämtliche der Abführungsseiten auf jenen Seiten angeordnet sind, die vom Gang abgewandt sind.

8. System nach einem der vorhergehenden Ansprüche, **dadurch gekennzeichnet, dass** der Kanal einen Teil eines Wegs ausbildet.

9. System nach einem der vorhergehenden Ansprüche, **dadurch gekennzeichnet, dass** der Kanal im Wesentlichen unterhalb der Vielzahl an Racks angeordnet ist.

10. System nach einem der vorhergehenden Ansprüche, **dadurch gekennzeichnet, dass** ein Gitter als ein Teil eines Bodens dient, der den Gang vom Kanal trennt.

11. System nach einem der vorhergehenden Ansprüche, **dadurch gekennzeichnet, dass** das Abdeckungselement transparent ist zur Ermöglichung einer Beleuchtung innerhalb des Gangs.

12. System nach einem der vorhergehenden Ansprüche, **dadurch gekennzeichnet, dass** der Gang ein Abschlusselement umfasst, das zum Abdichten des Gangs an einem seiner Enden ausgebildet ist.

13. System gemäß Anspruch 12, **dadurch gekennzeichnet, dass** das Abschlusselement eine Türe ist.

14. System nach Anspruch 13, **dadurch gekennzeichnet, dass** die Türe eine Schiebetüre ist.

15. System nach einem der vorhergehenden Ansprüche, **dadurch gekennzeichnet, dass** die Vielzahl an Racks eine Vielzahl an Einbauräumen zur Aufnahme einer Nutzlast umfasst.

16. System nach Anspruch 15, **dadurch gekennzeichnet, dass** die Nutzlast ein eigenes Medium-Fördermittel umfasst zum Fördern des Mediums von der Zuführungsseite zu der Abführungsseite seines Racks.

17. System nach Anspruch 15 oder 16, **dadurch gekennzeichnet, dass** die Einbauräume bezüglich der Nutzlast abgedichtet sind, um ein unkontrolliertes Strömen des Mediums durch die Racks zu verhindern.

18. System nach einem der Ansprüche 15 bis 17, **dadurch gekennzeichnet, dass** Einbauräume, die nicht durch eine Nutzlast belegt sind, zum Gang hin abgedichtet sind.

19. System nach einem der Ansprüche 15 bis 18, **dadurch gekennzeichnet, dass** die Zuführungsseite der Nutzlast mit der Zuführungsseite des Racks übereinstimmt, und die Abführungsseite der Nutzlast mit der Abführungsseite des Racks übereinstimmt.

20. System nach einem der vorhergehenden Ansprüche, ferner ein Fördermittel umfassend, das entlang des Wegs angeordnet ist, den entlang das Medium zwischen der Klimasteuereinheit und der Vielzahl an Racks ausgetauscht wird, wobei das Fördermittel zum Sammeln von Luft von innerhalb des Gehäuses und zum Fördern dieser in Richtung der Klimasteuereinheit ausgebildet ist.

21. System nach Anspruch 20, **dadurch gekennzeichnet, dass** die abgetastete Temperatur, die durch den Temperatursensor (335) erfasst wird, zwischen 22 und 26°C beträgt, und ein Abfallen der abgetasteten Temperatur das Fördermittel dazu veranlasst, ein Antreiben der kalten Luft aus der Klimasteuereinheit in den Kanal zu verringern.

22. System nach einem der vorhergehenden Ansprüche, **dadurch gekennzeichnet, dass** die Klimasteuereinheit dazu ausgebildet ist, mit wenigstens zwei verschiedenen Leistungsversorgungen verbunden zu sein, wobei wenigstens eine der Leistungsversorgungen unterbrechungsfrei ist.

23. System nach einem der vorhergehenden Ansprüche, **dadurch gekennzeichnet, dass** die Klimasteuereinheit und/oder das Fördermittel außerhalb des Gehäuses angeordnet sind.

24. Verfahren zum Steuern wenigstens eines Klimaparameters innerhalb einer Vielzahl an Racks (305, 310), die so angeordnet sind, dass sie wenigstens einen Gang (315) zwischen sich bilden, wobei das Verfahren umfasst:
- Steuern des wenigstens einen Klimaparameters eines gasförmigen Mediums;
- Austauschen des Mediums zwischen der Vielzahl an Racks und der Klimasteuereinheit durch einen Kanal, der dazu ausgebildet ist, das Medium in Richtung der Racks von unterhalb der Racks zuzuführen;
- Abtasten einer Temperatur am oberen Ende des Gangs als dem Klimaparameter,
**gekennzeichnet durch**
- Abdichten des Gangs an einem oberen Ende **durch** ein Abdeckungselement, das sich in einer horizontalen Ebene über den Gang erstreckt, oberhalb der Racks, und von den Racks vertikal beabstandet ist durch Elemente, die für das Medium undurchlässig sind, und wobei der Gang derart abgedichtet ist, dass im Wesentlichen das gesamte den Gang durchlaufende Medium die Racks durchläuft.

## Revendications

1. Système (300) pour réguler au moins un paramètre climatique à l'intérieur d'une pluralité de bâtis électroniques (305, 310) agencés de manière à former au moins une allée (315) entre eux, le système comprenant :
- au moins une unité de régulation climatique (320) adaptée à réguler l'au moins un paramètre climatique d'un milieu gazeux ;
- une conduite (330) pour échanger le milieu entre la pluralité de bâtis électroniques et l'unité de régulation climatique, la conduite étant adaptée à délivrer le milieu vers les bâtis électroniques par en-dessous les bâtis électroniques ;
- un capteur de température (335) situé au niveau d'une extrémité supérieure de l'allée et adapté à échantillonner une température comme le paramètre climatique, **caractérisé par**
- un élément de couvercle fermant de manière étanche l'allée au niveau d'une extrémité supérieure, l'élément de couvercle s'étendant dans un plan horizontal à travers l'allée, au-dessus des bâtis électroniques, et étant espacé verticalement des bâtis électroniques par des éléments qui ne sont pas perméables au milieu ; et dans lequel
- l'allée est fermée de manière étanche de façon à ce qu'essentiellement la totalité du milieu passant à travers la conduite passe à travers les bâtis électroniques.

2. Système selon la revendication 1, comprenant en outre un logement adapté à fermer un chemin le long duquel le milieu circule entre la pluralité de bâtis électroniques et l'unité de régulation climatique.

3. Système selon la revendication 1, **caractérisé en ce que** les bâtis électroniques ont un côté de délivrance pour délivrer le milieu aux bâtis électroniques et un côté d'évacuation pour évacuer le milieu des bâtis électroniques.

4. Système selon la revendication 3, **caractérisé en ce que** le côté d'évacuation est opposé au côté de délivrance.

5. Système selon la revendication 3, **caractérisé en ce que** le côté de délivrance et le côté d'évacuation sont sur des côtés différents du bâti électronique autres que des côtés opposés.

6. Système selon l'une des revendications 3 à 5, **caractérisé en ce que**, pour chaque allée, un des côtés de délivrance et des côtés d'évacuation de tous les bâtis électroniques adjacents à l'allée font face vers l'allée.

7. Système selon l'une des revendications 3 à 6, **caractérisé en ce que** la totalité des côtés de délivrance font face à l'allée et la totalité des côtés d'évacuation sont sur les côtés des bâtis électroniques qui font face à l'opposé de l'allée.

8. Système selon l'une des revendications précédentes, **caractérisé en ce que** la conduite forme une partie du chemin.

9. Système selon l'une des revendications précédentes, **caractérisé en ce que** la conduite est située essentiellement en-dessous de la pluralité de bâtis électroniques.

10. Système selon l'une des revendications précédentes, **caractérisé en ce qu'**une grille sert comme une partie de sol qui sépare l'allée de la conduite.

11. Système selon l'une des revendications précédentes, **caractérisé en ce que** l'élément de couvercle est transparent pour recevoir un éclairage à l'intérieur de l'allée.

12. Système selon l'une des revendications précédentes, **caractérisé en ce que** l'allée comprend un élément d'extrémité adapté à fermer l'allée de manière étanche à une de ses extrémités.

13. Système selon la revendication 12, **caractérisé en ce que** l'élément d'extrémité est une porte.

14. Système selon la revendication 13, **caractérisé en ce que** la porte est une porte coulissante.

15. Système selon l'une des revendications précédentes, **caractérisé en ce que** la pluralité de bâtis électroniques comprend une pluralité d'espaces de montage pour recevoir une charge utile.

16. Système selon la revendication 15, **caractérisé en ce que** la charge utile comprend un transporteur de milieu privé pour transporter un milieu du côté de délivrance jusqu'au côté d'évacuation de son bâti électronique.

17. Système selon la revendication 15 ou 16, **caractérisé en ce que** les espaces de montage sont fermés de manière étanche par rapport à la charge utile pour prévenir un écoulement non maîtrisé de milieu à travers les bâtis électroniques.

18. Système selon l'une des revendications 15 à 17, **caractérisé en ce que** des espaces de montage qui ne sont pas occupés par une charge utile sont fermés de manière étanche vers l'allée.

19. Système selon l'une des revendications 15 à 18, **caractérisé en ce que** le côté de délivrance de la charge utile correspond au côté de délivrance du bâti électronique, et le côté d'évacuation de la charge utile correspond au côté d'évacuation du bâti électronique.

20. Système selon l'une des revendications précédentes, comprenant en outre un transporteur situé le long du chemin le long duquel le milieu est échangé entre l'unité de régulation climatique et la pluralité de bâtis électroniques, le transporteur adapté à collecter de l'air de l'intérieur du logement et à le transporter vers l'unité de régulation climatique.

21. Système selon la revendication 20, **caractérisé en ce que** la température échantillonnée enregistrée par le capteur de température (335) se trouve entre 22 et 26°C, et une chute de la température échantillonnée fait que le transporteur diminue sa propulsion d'air froid de l'unité de régulation climatique dans la conduite.

22. Système selon l'une des revendications précédentes, **caractérisé en ce que** l'unité de régulation climatique est adaptée à être connectée à au moins deux alimentations électriques différentes, au moins une des alimentations électriques étant sans interruption.

23. Système selon l'une des revendications précédentes, **caractérisé en ce qu'**au moins un de l'unité de régulation climatique et du transporteur est situé à l'extérieur du logement.

24. Procédé de régulation d'au moins un paramètre climatique à l'intérieur d'une pluralité de bâtis électroniques (305, 310) agencés de manière à former au moins une allée (315) entre eux, le procédé comprenant :
- la régulation de l'au moins un paramètre climatique d'un milieu gazeux ;
- l'échange du milieu entre la pluralité de bâtis électroniques et l'unité de régulation climatique à travers une conduite délivrant le milieu vers les bâtis électroniques par en-dessous les bâtis électroniques ;
- l'échantillonnage d'une température au niveau d'une extrémité supérieure de l'allée comme le paramètre climatique ; **caractérisé par**
- la fermeture étanche de l'allée au niveau d'une extrémité supérieure par un élément de couvercle s'étendant dans un plan horizontal à travers l'allée, au-dessus des bâtis électroniques, et étant espacé verticalement des bâtis électroniques par des éléments qui ne sont pas perméables au milieu ; et dans lequel
- l'allée est fermée de manière étanche de façon à ce qu'essentiellement la totalité du milieu passant à travers la conduite passe à travers les bâtis électroniques.
